# EUROPEAN PATENT APPLICATION

(11) **EP 2 000 854 A2**
(43) Date of publication of application: **10.12.2008**
(21) Application number: 08156643.2
(22) Date of filing: 21.05.2008
(51) Int. Cl.: G03F 7/20

(54) **Substrate processing apparatus and method of manufacturing device**

(30) Priority: 04.06.2007 JP 2007148622
(71) Applicant: Canon Kabushiki Kaisha, Tokyo 146-8501 (JP)
(72) Inventor: Oki, Toshikazu, Tokyo Tokyo 146-8501 (JP)
(74) Representative: TBK-Patent

(57) **Abstract**

An apparatus according to the present invention includes a vacuum chamber (5) and processes a substrate (4) in the vacuum chamber (5). The apparatus includes pumps (8A, 8B; 9A, 9B) which exhaust the vacuum chamber (5), a first cryopump (7A) accommodated in the vacuum chamber (5), a second cryopump (7B) accommodated in the vacuum chamber (5), and a controller (15) which alternatively stops the first cryopump (7A) and the second cryopump (7B).

## Description

### BACKGROUND OF THE INVENTION

### Field of the Invention

The present invention relates to a substrate processing apparatus and a method of manufacturing a device.

### Description of the Related Art

Along with the recent advance in photolithography for manufacturing a semiconductor, the wavelength of exposure light has shortened from the i-line and g-line to the oscillation wavelengths of a KrF excimer laser and ArF excimer laser. As the wavelength of exposure light shortens, a finer mask pattern can be transferred onto a wafer. However, lithography using ultraviolet light has a theoretical limitation on transferring a pattern with a narrower line width by exposure. Under the circumstance, EUV lithography using extreme ultraviolet light (EUV light with a wavelength of 13 to 20 nm) with a wavelength shorter than that of ultraviolet light is attracting a great deal of attention.

Because a useful representative wavelength of EUV light is 13.5 nm, the EUV light can attain a resolution which largely surpasses that in the conventional photolithography, but is readily absorbed by various substances. When reduction exposure using a refractive optical system is performed with EUV light as in the conventional lithography using ultraviolet light for a light source, a glass material absorbs the EUV light. This enormously reduces the amount of light which reaches an exposure target body such as a wafer. To avoid this situation, reduction exposure with EUV light must use a reflective optical system.

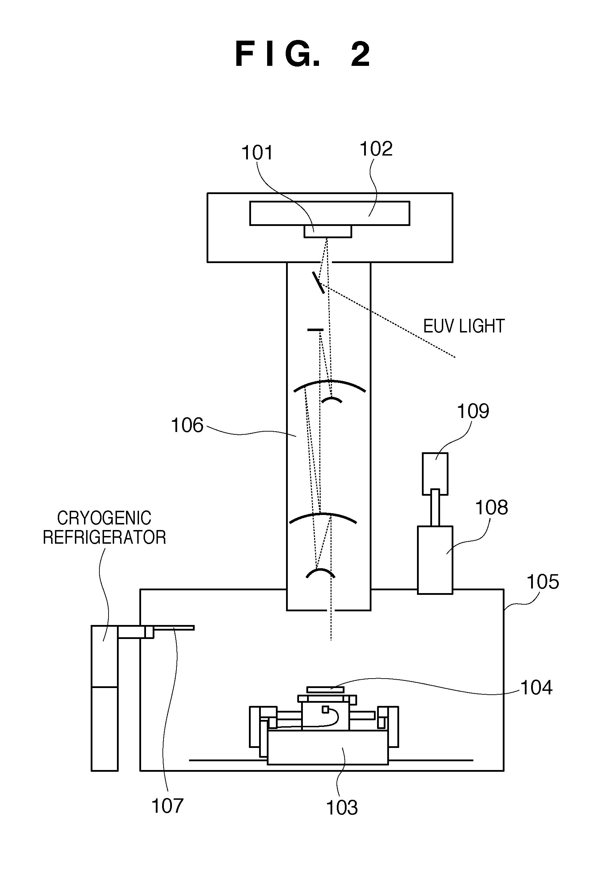

Fig. 2 is a schematic view showing a reduction projecting exposure apparatus using EUV light according to the prior art. The EUV exposure apparatus comprises an EUV light source (not shown), an illumination optical system (not shown), a reticle (mask) 101, a reticle stage 102, a substrate stage 103, a substrate 104, a vacuum chamber 105, and a reflective reduction projection optical system 106 including six mirrors. The exposure apparatus also comprises, e.g., an exhaust system for exhausting a gas in the vacuum chamber 105, a cryopump (cold trap) 107, a turbo molecular pump 108, and a dry pump 109.

EUV light used for an EUV exposure apparatus is readily absorbed by the atmosphere in the apparatus. Especially, oxygen and moisture strongly absorb the EUV light. To maintain the transmittance of the EUV light in a chamber, it is necessary to evacuate the chamber using, e.g., a vacuum pump, so the exposure apparatus often has a plurality of exhaust systems such as vacuum pumps. The pressure in the chamber through which the EUV light propagates is desirably 10⁻³ Pa or less, and the partial pressures of oxygen and moisture are desirably as low as possible.

However, as a substrate is transported, moisture and the like adhering on the substrate scatter in the chamber. Still worse, the moisture readily adheres on the chamber inner wall and is hardly exhausted. When the moisture adheres on an optical element, it oxidizes the optical element and consequently decreases the reflectance of the optical element.

As the chamber is evacuated, hydrocarbons are generated by mechanisms such as a stage. Hydrocarbons are also generated as exposure light reacts with a resist during exposure. When these hydrocarbons are irradiated with the exposure light on the optical element surface, they adhere on the optical element surface upon being dehydrogenated into carbon. The carbon adhering on the optical element absorbs the EUV light, resulting in a decrease in the reflectance of the optical element. The decrease in the reflectance of the optical element leads to a decrease in throughput.

Especially in the space in which the optical element is accommodated in the EUV exposure apparatus, the partial pressures of moisture and hydrocarbons must be kept sufficiently low. To drop the partial pressures of, e.g., moisture and hydrocarbons in the exposure apparatus, a cold trap type vacuum pump that is excellent in exhaust of contaminating molecules such as moisture and hydrocarbons is used.

The principle of a cold trap type vacuum pump will be explained herein. The cryogenic surface of this pump is inserted into a vacuum chamber to condense and absorb contaminating molecules in the chamber, thereby exhausting them outside the chamber. This pump is known to be excellent especially in exhaust of the molecules of water as compared with pumps of other mechanisms. This pump will be referred to as a cryopump (cold trap) hereinafter.

Japanese Patent Laid-Open No. 2005-101537 discloses an exposure apparatus in which two cryopumps are accommodated in a chamber to extend from a reticle to a substrate. The exposure apparatus described in this patent reference stops exposure processing in revitalizing the cryopumps. Japanese Patent Laid-Open No. 2005-353986 discloses an exposure apparatus in which cryopumps are placed in a projection optical system chamber to be immediately close to its exposure light transmitting openings on the wafer side and reticle side. These cryopumps respectively absorb and trap gasses isolated from the resist on the wafer and the reticle stage space. Even the exposure apparatus described in this patent reference stops exposure processing in revitalizing the cryopumps.

Unfortunately, since a cryopump is a collecting pump, its exhaust capability degrades after exhaust by a predetermined amount. To cope with this problem, revitalizing processing for discharging absorbed contaminating molecules in a gaseous phase by increasing the temperature of the exhaust surface must be performed periodically. During the revitalizing processing, substrate processing such as exposure cannot be performed because gaseous molecules are discharged. This results in a decrease in throughput.

### SUMMARY OF THE INVENTION

It is an exemplary object of the present invention to provide a substrate processing apparatus which can perform substrate processing even while a cryopump is revitalized.

According to the present invention, there is provided an apparatus which includes a vacuum chamber 5 and processes a substrate 4 in the vacuum chamber 5 as specified in claims 1 to 5.

According to the present invention, it is possible to provide a substrate processing apparatus which can perform substrate processing even while, e.g., a cryopump is revitalized.

Further features of the present invention will become apparent from the following description of exemplary embodiments with reference to the attached drawings.

### BRIEF DESCRIPTION OF THE DRAWINGS

Fig. 1 is a schematic view showing the entire exposure apparatus according to an embodiment of the present invention; and

Fig. 2 is a schematic view showing the entire exposure apparatus according to the prior art.

### DESCRIPTION OF THE EMBODIMENT

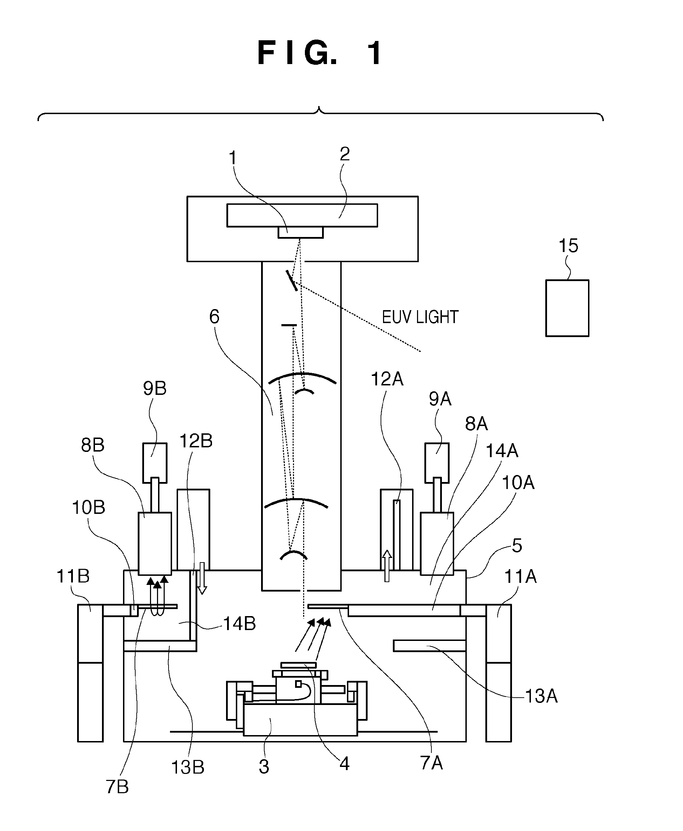

Fig. 1 shows an embodiment when a substrate processing apparatus which processes a substrate is an exposure apparatus which projects and transfers a pattern formed on a reticle onto a substrate with EUV light. The processing apparatus according to the present invention is not particularly limited to an exposure apparatus, and is applicable to a substrate processing apparatus which performs processing such as etching, vacuum deposition, and ion implantation on a substrate in a vacuum environment.

The exposure apparatus comprises an EUV light source (not shown), an illumination optical system (not shown), a reticle (mask) 1, a reticle stage 2, a substrate stage 3, a substrate 4, a vacuum chamber 5, and a reflective reduction projection optical system 6 including six mirrors. The exposure apparatus also comprises cryopumps 7A and 7B, turbo molecular pumps 8A and 8B, and dry pumps 9A and 9B as an exhaust system which exhausts a gas in the chamber 5, and maintains the internal space of the chamber 5 in a vacuum environment.

The EUV light source (not shown) includes several types. A laser produced plasma light source as one of these types can emit light components in an almost only necessary wavelength range by selecting the target material. For example, when Xe is sprayed from a pulse nozzle as the target material and irradiated with a pulse laser to generate a plasma, EUV light in a wavelength range of 13 to 14 nm is emitted. The illumination optical system (not shown) includes, e.g., a plurality of multi-layer mirrors and optical integrator. The role of the illumination optical system includes, e.g., efficiently converging light emitted by the light source, and uniforming the illuminance in an exposure region. The optical integrator also plays a role of uniformly illuminating a mask with a predetermined numerical aperture.

The reflective reduction projection optical system 6 includes a plurality of multi-layer mirrors formed by coating a base with Mo and Si alternately. Since the multi-layer mirror has a normal incidence reflectance of about 67% with respect to EUV light, most of energy absorbed by the multi-layer mirror transforms into heat. In view of this, a low-thermal expansion glass or the like is used as the mirror base material.

The reticle stage 2 and substrate stage 3 have mechanisms driven under a vacuum environment, and can be scanned in synchronism with a speed ratio proportional to the reduction magnification. The positions and orientations of the reticle stage 2 and substrate stage 3 are observed and controlled by laser interferometers (not shown). The reticle (mask) 1 is held by a reticle chuck on the reticle stage 2. The substrate 4 is held by a substrate chuck on the substrate stage 3. The reticle stage 2 and substrate stage 3 respectively have fine positioning mechanisms and can position the reticle 1 and substrate 4.

An alignment detection mechanism (not shown) measures the positional relationship between the reticle 1 and the optical axis of the projection optical system 6 and that between the substrate 4 and the optical axis of the projection optical system 6. On the basis of the measurement result, the positions and angles of the reticle stage 2 and substrate stage 3 are adjusted so that a projected image of the reticle 1 matches a predetermined position. A focus position detection mechanism (not shown) detects the focus position of the reticle pattern in the vertical direction on the substrate surface to maintain the imaging position of the projection optical system 6 on the substrate surface. After the completion of one exposure, the substrate stage 3 moves in the X and Y directions step by step and reaches the next exposure start position, and exposure is performed again.

In this embodiment, the exposure apparatus comprises the plurality of (two) cryopumps 7A and 7B as cold traps, and absorbs contaminating molecules in the internal space of the chamber 5. The cryopumps 7A and 7B have panel type cooling surfaces. These panels are connected to cryogenic refrigerators 11A and 11B outside the apparatus via tubes, are cooled by compressed liquid helium, and exhaust the internal gas. The exposure apparatus comprises a plurality of (two) partitions having openable/closable doors 12A and 12B. These partitions form, in the chamber 5, a plurality of (two) enclosed spaces 14A and 14B which surround the cryopumps 7A and 7B by closing the doors 12A and 12B. The wall of the chamber 5, fixed walls 13A and 13B projecting from the wall of the chamber 5, and the doors 12A and 12B in a closed state constitute partitions which form the enclosed spaces 14A and 14B. The cryopumps 7A and 7B are revitalized in the enclosed spaces 14A and 14B. When the spaces 14A and 14B are enclosed by the doors 12A and 12B, the spaces 14A and 14B form revitalizing processing spaces for revitalizing the cryopumps 7A and 7B. A space other than the enclosed spaces 14A and 14B in the chamber 5 can be an exposure space. The doors 12A and 12B are opened/closed by opening/closing mechanisms. The doors 12A and 12B are made of a heat-insulating material and can suppress heat generated upon revitalizing the cryopumps 7A and 7B from being conducted to the exposure space. The turbo molecular pumps 8A and 8B and dry pumps 9A and 9B are accommodated in the spaces 14A and 14B. The cryopumps 7A and 7B constitute a first cold trap and second cold trap, respectively. The doors 12A and 12B constitute a first door and second door, respectively. The two partitions constitute a first partition and second partition, respectively.

The cryopumps 7A and 7B are movably held by first and second extendable arms 10A and 10B. The moving mechanisms which move the cryopumps 7A and 7B need not always be arms. The door opening/closing mechanisms and moving mechanisms (arms) are controlled by a controller 15. The first and second arms 10A and 10B constitute a first moving mechanism and second moving mechanism.

When one arm 10A is extended, the cryopump 7A held by the arm 10A moves close to the substrate 4 and can efficiently exhaust moisture and hydrocarbons generated upon exposure. At this time, the door 12A is not closed and therefore the space 14A is not enclosed. On the other hand, the other arm 10B is contracted and therefore the space 14B is enclosed by closing the door 12B. The cryopump 7B is accommodated near the turbo molecular pump 8B in the enclosed space 14B. The cryopump 7B in the enclosed space 14B stops the refrigeration function of the cryogenic refrigerator 11B and is revitalized at normal temperature. To quickly discharge absorbed gaseous molecules, the cooling surface can be heated by setting a heater (not shown) on the cooling surface. In this case, the member of the openable/closable door 12B needs to be insulated from heat. The discharged gas (contaminating molecules) is smoothly exhausted outside the apparatus by the turbo molecular pump 8B and dry pump 9B.

That is, in forming an enclosed space by closing the door of one partition, the controller 15 controls door driving mechanisms so as not to close the door of at least one of the other partitions. Also, in revitalizing one cryopump, the controller 15 controls the driving mechanisms and moving mechanisms (arms) so as to insert the cryopump into the enclosed space and insert at least one of the other cryopumps into the exposure space and, preferably, near the substrate stage.

A pressure sensor (not shown) is accommodated in the revitalizing processing space and can confirm whether revitalizing processing is complete. After the completion of the revitalizing processing, when it is confirmed that the pressure in the revitalizing processing space matches the degree of vacuum in the exposure space or that the pressure matches a degree of vacuum which does not adversely affect that of the exposure space, the door partitioning the enclosed space is opened.

The controller 15 alternately revitalizes the cryopumps 7A and 7B one by one. For this reason, one cryopump can absorb contaminating molecules in the chamber 5 as the exposure space while the other cryopump is revitalized. The cryopump is revitalized in an enclosed space that is smaller than the chamber 5. Since a gas discharged from the cryopump being revitalized scatters only in the enclosed space, the turbo molecular pump and the like can efficiently perform the revitalizing processing. The pump which exhausts a gas (contaminating molecules) discharged from the cryopump being revitalized is not particularly limited to a turbo molecular pump or dry pump, and at least one of, e.g., a rotary pump and oil diffusion pump can also be used.

These cryopumps are preferably revitalized in the enclosed spaces formed by the partitions and doors. However, if one cryopump can sufficiently absorb a gas (contaminating molecules) discharged while the other cryopump is revitalized, these cryopumps need not always be revitalized in the enclosed spaces formed by the partitions and doors.

If neither of these two cryopumps requires revitalizing processing, they can be used at once to exhaust the exposure space. This allows exhaust by lowering the refrigeration capabilities of the refrigerators as compared with a case in which one cryopump is activated at one time. In this case, the cryogenic refrigerators can be controlled by pressure sensors (not shown) accommodated in the apparatus and temperature sensors (not shown) set on the exhaust surfaces of the cryopumps 7A and 7B.

This embodiment has assumed that the plurality of cryopumps 7A and 7B are held by the movable, extendable arms 10A and 10B. However, the present invention is applicable even when the plurality of cryopumps 7A and 7B are not held by extendable arm members, although their capabilities to exhaust moisture and hydrocarbons generated in the exposure space degrade. Furthermore, even when only one cryopump and partition are provided, the cryopump is revitalized in the enclosed revitalizing processing space so that a gas discharged from the cryopump being revitalized never enters the exposure space. This makes it possible to perform exposure processing using the exposure space even while the cryopump is revitalized.

This embodiment has exemplified a substrate stage chamber which accommodates a substrate stage for holding a substrate. However, the present invention is also applicable to a reticle stage chamber which accommodates a reticle stage for holding a reticle, and a projection optical system and illumination optical system which include reflective optical elements.

An embodiment of a method of manufacturing a device using the above-described exposure apparatus will be explained next.

Devices (e.g., a semiconductor integrated circuit device and liquid crystal display device) are manufactured by a step of exposing a substrate coated with a photosensitive agent to radiant energy using the above-described exposure apparatus, a step of developing the substrate exposed in the exposing step, and other known steps.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

An apparatus according to the present invention includes a vacuum chamber (5) and processes a substrate (4) in the vacuum chamber (5). The apparatus includes pumps (8A, 8B; 9A, 9B) which exhaust the vacuum chamber (5), a first cryopump (7A) accommodated in the vacuum chamber (5), a second cryopump (7B) accommodated in the vacuum chamber (5), and a controller (15) which alternatively stops the first cryopump (7A) and the second cryopump (7B).

## Claims

1. An apparatus which includes a vacuum chamber 5 and processes a substrate 4 in the vacuum chamber 5, the apparatus comprising:
pumps 8A,8B;9A,9B configured to exhaust the vacuum chamber 5;
a first cryopump 7A accommodated in the vacuum chamber 5;
a second cryopump 7B accommodated in the vacuum chamber 5; and
a controller 15 configured to alternatively stop the first cryopump 7A and the second cryopump 7B.

2. An apparatus according to claim 1, further comprising:
a first openable/closable partition 12A configured to isolate the first cryopump 7A in the vacuum chamber 5; and
a second openable/closable partition 12B configured to isolate the second cryopump 7B in the vacuum chamber 5,
wherein the controller 15 is configured to control the first partition 12A and the second partition 12B so that the first partition 12A and the second partition 12B are alternatively closed in accordance with the alternative stopping.

3. An apparatus according to claim 1, further comprising:
a first openable/closable partition 12A configured to isolate the first cryopump 7A in the vacuum chamber 5;
a second openable/closable partition 12B configured to isolate the second cryopump 7B in the vacuum chamber 5;
a first moving mechanism configured to move the first cryopump 7A; and
a second moving mechanism configured to move the second cryopump 7B,
wherein the controller 15 is configured to control the first partition 12A, the second partition 12B, the first moving mechanism, and the second moving mechanism so that the first cryopump 7A is positioned in a space 14A isolated by the first partition 12A while the first cryopump 7A is stopped, and so that the second cryopump 7B is positioned in a space 14B isolated by the second partition 12B while the second cryopump 7B is stopped.

4. An apparatus which includes a vacuum chamber 5 and processes a substrate 4 in the vacuum chamber 5, the apparatus comprising:
pumps 8A, 8B; 9A, 9B configured to exhaust the vacuum chamber 5;
a cryopump 7A accommodated in the vacuum chamber 5;
an openable/closable partition 12A configured to isolate a space 14A including the cryopump 7A in the vacuum chamber 5; and
a controller 15 configured to cause the partition 12A to isolate the space 14A including the cryopump 7A, cause the isolated cryopump 7A stop, and cause one of the pumps 8A, 8B; 9A, 9B to exhaust the isolated space 14A.

5. An apparatus according to claim 4, further comprising a moving mechanism configured to move the cryopump 7A,
wherein the controller 15 is configured to control the moving mechanism so that the cryopump 7A is positioned in the space 14A isolated by the partition 12A while the cryopump 7A is stopped.

6. An apparatus according to any preceding claim,
wherein the apparatus is configured to expose the substrate to radiant energy in the vacuum chamber.

7. A method of manufacturing a device, the method comprising:
exposing a substrate to radiant energy using an apparatus defined in claim 6;
developing the exposed substrate; and
processing the developed substrate to manufacture the device.
